# EUROPEAN PATENT APPLICATION

(11) **EP 4 654 472 A1**
(43) Date of publication of application: **26.11.2025**
(21) Application number: 24177639.2
(22) Date of filing: 23.05.2024
(51) Int. Cl.: H03F 3/19, H03F 3/24, H03G 1/00, H03G 3/30

(54) **A VOLTAGE GAIN CONTROL CIRCUIT**

(71) Applicant: NXP B.V., 5656 AG Eindhoven (NL)
(72) Inventor: JANSSON, Lars Gustaf, 5656 AG Eindhoven (NL); YANG, Xin, 5656 AG Eindhoven (NL)
(74) Representative: Schmütz, Christian Klaus Johannes

(57) **Abstract**

A voltage gain control circuit comprising: a current-to-current conversion circuit comprising; a first current mirror transistor; a second current mirror transistor; and a current mirror transistor, the voltage gain control circuit further comprising and a current-to-voltage conversion circuit, wherein an input of the current-to-voltage conversion circuit is coupled to an output of the current-to-current conversion circuit and wherein the current-to-voltage conversion circuit is configured to provide an output voltage signal which varies proportionately to a signal received at the input of the current-to-voltage conversion circuit, and wherein the configuration of the current-to-current conversion circuit is such that a linear current variation in the received linear control current results in an exponential current variation in an output current of the current-to-current conversion circuit provided to the current-to-voltage circuit via the second CMT input terminal.

## Description

### Field

The present disclosure relates to a voltage gain control circuit, a receiver or transmitter circuit, a beamforming circuit and a beamcapturing circuit.

### Summary

According to a first aspect of the present disclosure, there is provided a voltage gain control circuit comprising: a current-to-current conversion circuit comprising; a first current mirror transistor, CMT, comprising a first CMT control terminal, a first CMT input terminal and a first CMT output terminal; a second current mirror transistor, CMT, comprising a second CMT control terminal, a second CMT input terminal and a second CMT output terminal; and a first current mirror resistor, wherein: the first CMT control terminal is coupled to the second CMT control terminal, the first CMT control terminal and the second CMT control terminal are coupled to the first CMT input terminal, the first CMT input terminal is coupled to a current-to-current conversion circuit input terminal which is configured to receive a linear control current; the first CMT output terminal is coupled to a reference voltage terminal via the first current mirror resistor; and the second CMT output terminal is coupled to the reference voltage terminal; a current-to-voltage conversion circuit, wherein an input of the current-to-voltage conversion circuit is coupled to the second CMT input terminal and wherein the current-to-voltage conversion circuit is configured to provide an output voltage signal which varies proportionately to a signal received at the input of the current-to-voltage conversion circuit from the second CMT input terminal, and wherein the configuration of the current-to-current conversion circuit is such that a linear current variation in the received linear control current results in an exponential current variation in an output current of the current-to-current conversion circuit provided to the current-to-voltage circuit via the second CMT input terminal.

In one or more embodiments, the first CMT and the second CMT may be bipolar junction transistors (BJTs) and wherein the first and second CMT control terminals are first and second bases, respectively, the first and second CMT input terminals are first and second collector terminals, respectively, and the first and second CMT output terminals are first and second emitter terminals, respectively.

In one or more embodiments, the current-to-voltage circuit may be configured to provide the output voltage signal as a differential output voltage signal.

In one or more embodiments, the current-to-voltage circuit may comprise a polarity switching circuit configured to provide for switching of the polarity of the differential output voltage signal based on receipt of a switching control signal.

In one or more embodiments, the current-to-current conversion circuit may further comprise a helper transistor wherein the helper transistor comprises: a helper transistor control terminal coupled to the input terminal of both the first CMT and the current-to-current conversion circuit input terminal; a helper transistor output terminal coupled to a supply voltage terminal configured to receive a supply voltage; and a helper transistor input terminal coupled to first CMT control terminal and the second CMT control terminal.

In one or more embodiments, the helper transistor may be a MOSFET transistor, wherein the helper control terminal is a helper gate terminal, the helper input terminal is a helper source terminal and the helper output terminal is a helper drain terminal.

In one or more embodiments, the current-to-current conversion circuit may further comprise a bleeder current source configured to provide a bias current to the helper transistor.

In one or more embodiments, the voltage gain control circuit may comprise a linear current generation circuit wherein the linear current generation circuit comprises a fixed current generation circuit configured to generate a fixed current and a variable current generation circuit configured to generate a variable current based on a control signal and wherein the linear control current is based on the fixed current and the programmable current.

In one or more embodiments, varying the variable current may vary a ratio of the fixed current to the variable current and the output current of the current-to-current conversion circuit may be based on the ratio of the fixed current to the variable current. The shifts the input current of the current-to-current conversion circuit generated by varying the variable current cause the operating range of the circuit to change, thereby providing a flexible system which does not require changes to its fundamental components to adjust the operating range.

According to a second aspect of the present disclosure, there is provided a transmitter circuit for an analog-beamforming circuit comprising the voltage gain control circuit of the first aspect and further comprising an antenna configured to use the output voltage signal of the current-to-voltage conversion circuit to generate a transmission signal.

In one or more embodiments, the first current mirror resistor may be a variable resistor and wherein varying the resistance of the first current mirror resistor varies a ratio of the current gain applied between the first CMT output terminal and the second CMT output terminal. As has been mentioned previously, the circuit provides an output that is linear in dB. Changing the resistance of the variable resistor changes the gradient of the slope of the gain applied.

In one or more embodiments, the transmitter circuit may further comprise a phase shifter circuit and a power amplifier wherein the phase shifter circuit and the power amplifier circuit are coupled in series with the voltage gain control circuit and the antenna.

According to a third aspect of the present disclosure, there is provided a beamforming circuit comprising a plurality of transmitter circuits of the second aspect.

According to a fourth aspect of the present disclosure, there is provided a receiver circuit for an analog-beamcapturing circuit comprising the voltage gain control circuit of the first aspect and further comprising an antenna configured to receive a wireless signal wherein the receiver circuit is configured to use the voltage gain control circuit to apply a voltage gain to the received wireless signal.

According to a fifth aspect of the present disclosure, there is provided a beamcapturing circuit comprising a plurality of receiver circuits of the fourth aspect.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

### Brief Description of the Drawings

One or more embodiments will now be described by way of example only with reference to the accompanying drawings in which:
Figure 1 shows an example embodiment of a voltage gain control circuit of the present disclosure;
Figure 2 shows a further example embodiment of a voltage gain control circuit of the present disclosure;
Figure 3 shows an example embodiment of a transmitter circuit according to the present disclosure;
Figure 4 shows an example embodiment of a beamforming circuit according to the present disclosure;
Figure 5 shows an example embodiment of a receiver circuit according to the present disclosure; and
Figure 6 shows an example embodiment of a beamcapturing circuit according to the present disclosure.

### Detailed Description

The present disclosure relates to a voltage gain control circuit which is configured to generate an exponentially varying voltage output signal from a linearly varying current input signal. The exponentially varying output voltage signal corresponds to a linearly varying voltage signal when measured in decibels (dB). The voltage gain control circuit may be used in a transmitter circuit which may form part of a transmitter line-up in an analog-beamforming circuit, such as a 6G beamforming system. The voltage gain control circuit may also be useful in other applications where it is necessary to provide for a simple conversion from a linear input current signal to an exponentially varying output voltage signal.

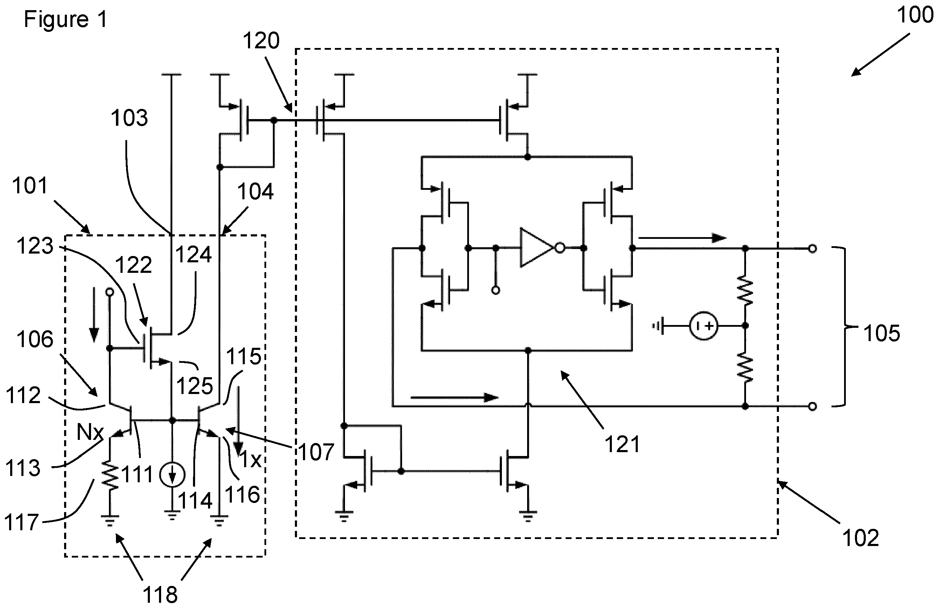

Figure 1 shows an example voltage gain control circuit 100 according to the present disclosure. The voltage gain control circuit 100 comprises a current-to-current (I2I) circuit 101 which is configured to take a linearly varying input current signal at an I2I input terminal 103 and convert the signal to an exponentially varying current signal at an output terminal 104 of the I2I circuit. The voltage gain control circuit further comprises a current-to-voltage (I2V) circuit 102 which is configured to convert the exponentially varying current signal from the output terminal 104 of the I2I circuit into an exponentially varying voltage signal at an output terminal 105 of the I2V circuit 102. It will be appreciated that an exponentially varying output voltage signal can be considered as a linearly varying output voltage signal when measured in decibels. This may be particularly advantageous for transmitters implemented in 6G beamforming systems. Further, it will be appreciated that being able to provide for voltage control of the output signal represents providing for a control of the gain of the output signal as compared to the input signal.

The I2I conversion circuit 101 achieves the linear to exponential current conversion by making use of a current mirror arrangement which comprises two transistors 106, 107 that provide for exponential multiplication of a received current signal. Bipolar Junction Transistors (BJTs) are a well-known example of a transistor which provides for an exponential relationship between their base-emitter current and the collector current. Where the two transistors 106, 107 are BJTs, the terminals of the BJT may be referred to as the base terminal, the emitter terminal and the collector terminal. However, while BJTs may be used as the transistors of the current mirror arrangement in one or more embodiments, any transistor or transconductor which provides for a similar exponential relationship may also be used, such as a MOS transistor operating in weak inversion, for example. For the sake of generality, the terminal which controls the current flow through the transistor (the base terminal in a BJT) may be referred to as the control terminal; the terminal which receives current (the collector in a BJT) may be referred to as an input terminal; and the terminal which outputs current (the emitter in a BJT) may be referred to as an output terminal.

The current mirror arrangement comprises at least a first current mirror transistor, CMT, 106 comprising a first CMT control terminal 111, a first CMT input terminal 112 and a first CMT output terminal 113 and a second current mirror transistor, CMT, 107 comprising a second CMT control terminal 114, a second CMT input terminal 115 and a second CMT output terminal 116; and a first current mirror resistor 117. In the current mirror arrangement, the first CMT control 111 terminal is coupled to the second CMT control terminal 114 and the first and second CMT control terminals 111, 114 are coupled to the first CMT input terminal 112. The first CMT input terminal 112 is further coupled to the I2I conversion circuit input terminal 103 which is configured to receive a linear control current. The first CMT output terminal 113 is coupled to a reference voltage terminal 118 via the first current mirror resistor. That is, a first terminal of the first current mirror resistor 117 is coupled to the first CMT output terminal 113 and a second, opposing, terminal of the first current mirror resistor 117 is coupled to the reference voltage terminal 118.

When the circuit is properly biased, the voltage over the resistor will set the voltage at the second CMT control terminal 114 (i.e. base of the second CMT). In other words, the linear input current will create a linear voltage over resistor 117. It is this linear voltage when applied to the base of the second CMT which will create an exponential current in second CMT.

It will be appreciated that the I2I circuit 101 disclosed herein provides a particularly component-light circuit structure for providing an exponentially varying current based on a linearly varying current which may take up particularly low amounts of chip space. The disclosed I2I circuit 101 may further make use of components which make it simpler to implement leading to less area and less power consumption than alternative solutions. Having fewer components also translates to reduced sensitivity to component-to-component mismatch.

Any reference voltage terminal 118 referred to herein may comprise a ground node set to a relative zero volts. Any reference voltage terminal 118 may be set to a same relative voltage as one or more of the other reference voltage terminals 118, or one or more reference voltage terminals may be set to different reference voltages, as is appropriate to enable operation of the circuits in the described manner. It will further be appreciated that, typically, reference voltage terminals 118, such as a ground node, are only considered coupled to ground when the circuit is coupled to a power source. As such, references to terminals being couplable to ground are understood by the skilled person as being a clear reference that such a circuit does not need to be coupled to a power source to be a circuit according to the present disclosure but is configured to be so coupled in use.

The current-to-voltage (I2V) conversion circuit 102 is coupled at an input terminal 120 of the I2V circuit 102 to the second CMT input terminal 116 of the I2I conversion circuit 101 such that the I2I conversion circuit 101 provides a current signal to the I2V conversion circuit 102 which varies exponentially in response to linear variations in the current of the linear input current of the I2I conversion circuit 101. The I2V conversion circuit 102 generates an output voltage signal which varies exponentially in line with exponential variations in the current received from the I2I conversion circuit 101. It will be appreciated that "such that" here refers to the fact that the described structure necessarily results in the exponentially varying response. While figure 1 shows an example of one implementation of an I2V conversion circuit 102, any suitable I2V circuit may be used. The exact circuit implementation details do not matter for the I2V circuit as long as the functionality is provided as described.

The I2V conversion circuit 102 may be configured to provide a single-ended output (not shown in the figures) at a single output signal terminal, or it may be configured to provide a differential output signal (as shown in the figures) between first and second output signal terminals 105.

The I2V conversion circuit 102 may further comprise a polarity switching circuit 121 configured to provide for switching of the polarity of the differential output voltage signal based on receipt of a switching control signal. For example, the polarity switching circuit 121 may comprise one or more control nodes which are configured to receive the switching control signal 121. The switching control signal may be configured to switch between one of two different states, such as between an "on" state and an "off" state, a "1" state and a "0" state or a "positive" state and a "negative" state, for example. However the states are labelled, the effect of switching from one state to the other state will have the functionality of switching the polarity of the output voltage signal between the first and second output signal terminals where first and second output signal terminals 105 are used to provide a differential output signal.

The I2I conversion circuit 101 may further comprise a common circuit called a β-helper transistor 122. Its function is to provide base currents for the first and second current mirror transistors 112 and 115. Without this circuit, the base current may reduce the linear input control current and cause an undesirable error. The helper transistor 122 may be configured to buffer the voltage between the I2I conversion circuit input terminal 103 and the control terminals 111, 114 of the first and second current mirror transistors 106, 107. The helper transistor 122 may comprise a helper control terminal 123 coupled to the first CMT input terminal 112 and the I2I conversion circuit input terminal 103. The helper transistor 122 further comprises an output terminal 124 coupled to a supply voltage terminal configured to receive a supply voltage in use. The helper transistor further comprises a helper input terminal 125 coupled to the first CMT control terminal 111 and the second CMT control terminal 114. The helper transistor 122 may be, for example, a NMOS transistor or a NPN transistor. The helper control terminal 123 may be a helper gate terminal; the helper input terminal 125 may be a helper source terminal and the helper output terminal 124 may be a helper drain terminal, for example.

The I2I conversion circuit 101 may further comprise a bleeder current source (not shown) configured to provide a bias current to the first CMT control terminal 111 and the second CMT control terminal 114. The bleeder current source may provide a bias current for the β-helper transistor 122 and needs to be larger than the maximum base current. The loop that is formed with the β-helper transistor transistors 122 and the first current mirror transistor 106 may also benefit from a stability network at the helper transistor control terminal 123 in the form of a capacitor or a capacitor and resistor in series. The bleeder current source maybe a current source or a resistor.

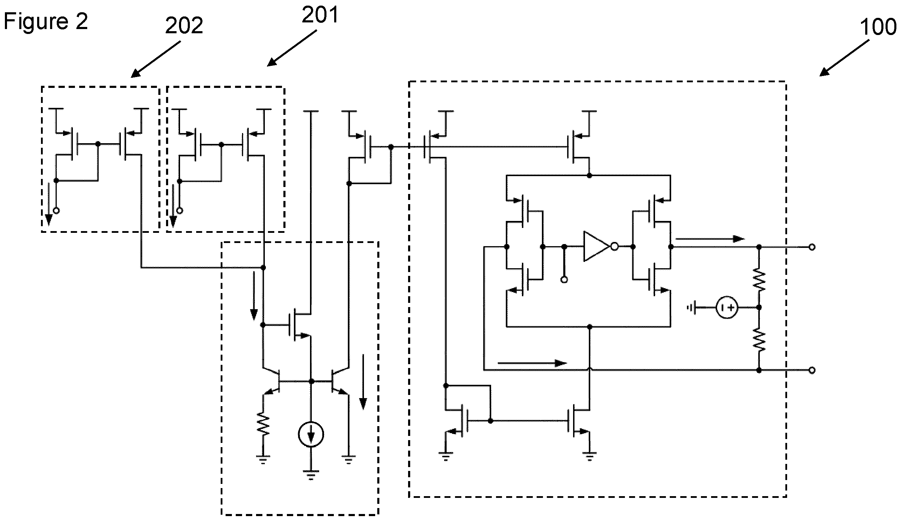

Figure 2 shows a further example embodiment of the voltage gain control circuit 100 of the present disclosure comprising the I2I and I2V conversion circuits 101, 102 of figure 1 and further comprising a fixed current generation circuit 201 and a variable current generation circuit 202. The fixed current generation circuit 201 may be configured to generate a fixed current as a current source as a result of a fixed received input current to the fixed current generation circuit 201. This may be achieved by implementing the fixed current generation circuit 201 as a current mirror circuit. The current mirror circuit of the fixed current generation circuit 201 may comprise a pair of MOSFET transistors, for example. Similarly, the variable current generation circuit 202 may be configured to generate a variable current as a current source as a result of a variable received input current to the variable current generation circuit 202. This may be achieved by implementing the variable current generation circuit 202 as a current mirror wherein an input current to the current mirror is variable. The current mirror of the variable current generation circuit 202 may comprise a pair of MOSFET transistors, for example. It will be appreciated that the fixed and variable current generation circuits 201, 202 may be implemented in different ways other than those described here. For example, PNP transistors could be used.

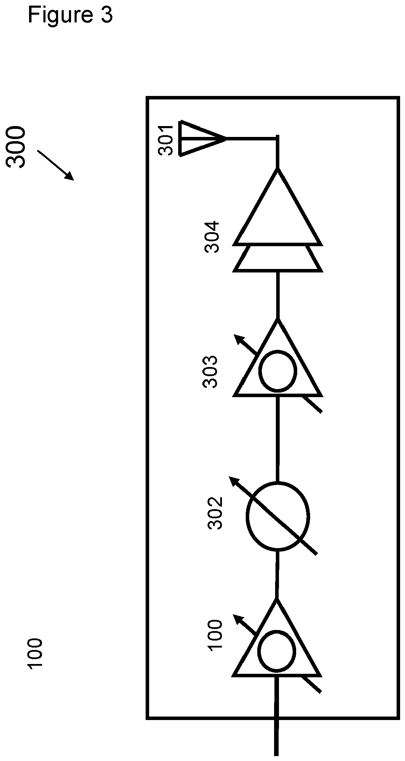

Figure 3 shows an example transmitter circuit 300 for an analog-beamforming circuit comprising the voltage gain control circuit 100 of figure 1 or figure 2. The transmitter circuit 300 further comprises an antenna 301 configured to use the output voltage signal of the current-to-voltage conversion circuit, or a signal derived therefrom, to generate a transmission signal.

The transmitter circuit 300 may further comprise, additional components such as, for example, a fine phase shifter circuit 302, a coarse phase shifter circuit 303 and a power amplifier circuit 304. Alternatively, a single phase shifter circuit may be provided instead of separate coarse and fine circuits. The fine and coarse phase shifter circuits 302, 303 may be configured to apply coarse and fine phase shifts, respectively. The amplifier circuit 304 may comprise a single-stage or multi-stage power amplifier. While the voltage gain control circuit 100, fine phase shifter circuit 302 and coarse phase shifter circuit 303 are depicted in a particular order in figure 3, it will be appreciated that, in practice, these may be provided in substantially any order prior to the power amplifier circuit 304 and the antenna 301.

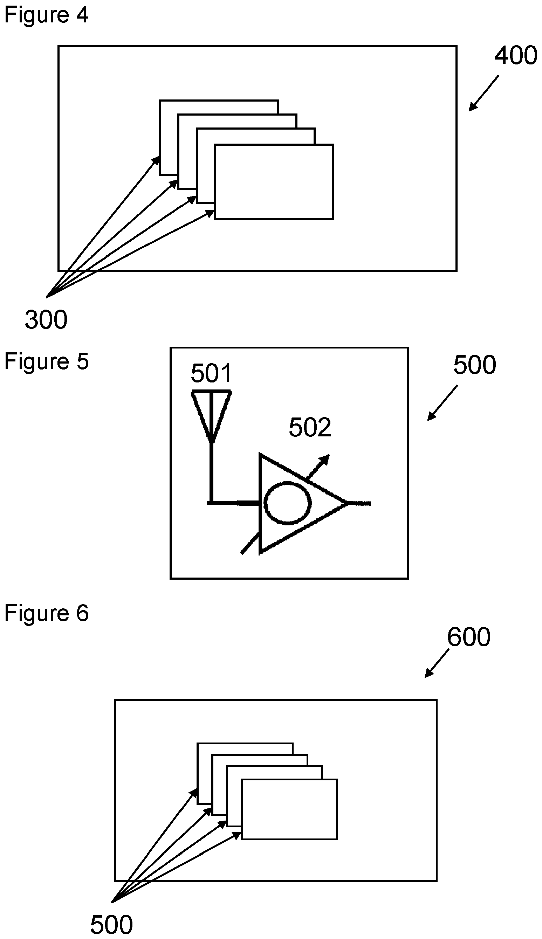

Figure 4 shows an example beam-forming circuit 400 comprising a plurality of transmitter circuits 300 of figure 4.

Figure 5 shows an example receiver circuit 500 for an analog-beamcapturing circuit comprising the voltage gain control circuit 100 of figure 1 or figure 2 and a receiver. It will be appreciated that the beamcapturing circuit may comprise one or more additional components located between the receiver and the voltage gain control circuit.

Figure 6 shows an example beamcapturing circuit 600 comprising a plurality of receiver circuits 500 of figure 5. In one or more examples, each beamcapturing circuit may comprise 16 antennas which each need to be tuned in phase and amplitude in order to virtually "point" in a particular same direction.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. A voltage gain control circuit comprising:
a current-to-current conversion circuit comprising;
a first current mirror transistor, CMT, comprising a first CMT control terminal, a first CMT input terminal and a first CMT output terminal;
a second current mirror transistor, CMT, comprising a second CMT control terminal, a second CMT input terminal and a second CMT output terminal; and
a first current mirror resistor, wherein:
the first CMT control terminal is coupled to the second CMT control terminal,
the first CMT control terminal and the second CMT control terminal are coupled to the first CMT input terminal,
the first CMT input terminal is coupled to a current-to-current conversion circuit input terminal which is configured to receive a linear control current;
the first CMT output terminal is coupled to a reference voltage terminal via the first current mirror resistor; and
the second CMT output terminal is coupled to the reference voltage terminal;
a current-to-voltage conversion circuit, wherein an input of the current-to-voltage conversion circuit is coupled to the second CMT input terminal and wherein the current-to-voltage conversion circuit is configured to provide an output voltage signal which varies proportionately to a signal received at the input of the current-to-voltage conversion circuit from the second CMT input terminal, and
wherein the configuration of the current-to-current conversion circuit is such that a linear current variation in the received linear control current results in an exponential current variation in an output current of the current-to-current conversion circuit provided to the current-to-voltage circuit via the second CMT input terminal.

2. The voltage gain control circuit of claim 1 wherein the first CMT and the second CMT are bipolar junction transistors (BJTs) and wherein the first and second CMT control terminals are first and second bases, respectively, the first and second CMT input terminals are first and second collector terminals, respectively, and the first and second CMT output terminals are first and second emitter terminals, respectively.

3. The voltage gain control circuit of any preceding claim wherein the current-to-voltage circuit is configured to provide the output voltage signal as a differential output voltage signal.

4. The voltage gain control circuit of claim 3 wherein the current-to-voltage circuit comprises a polarity switching circuit configured to provide for switching of the polarity of the differential output voltage signal based on receipt of a switching control signal.

5. The voltage gain control circuit of any preceding claim wherein the current-to-current conversion circuit further comprises a helper transistor wherein the helper transistor comprises:
a helper transistor control terminal coupled to the input terminal of both the first CMT and the current-to-current conversion circuit input terminal;
a helper transistor output terminal coupled to a supply voltage terminal configured to receive a supply voltage; and
a helper transistor input terminal coupled to first CMT control terminal and the second CMT control terminal.

6. The voltage gain control circuit of claim 5 wherein the helper transistor is a MOSFET transistor, wherein the helper control terminal is a helper gate terminal, the helper input terminal is a helper source terminal and the helper output terminal is a helper drain terminal.

7. The voltage gain control circuit of any of claims 5 or 6 wherein the current-to-current conversion circuit further comprises a bleeder current source configured to provide a bias current to the helper transistor.

8. The voltage gain control circuit of any preceding claim further comprising a linear current generation circuit wherein the linear current generation circuit comprises a fixed current generation circuit configured to generate a fixed current and a variable current generation circuit configured to generate a variable current based on a control signal and wherein the linear control current is based on the fixed current and the programmable current.

9. The voltage gain control circuit of claim 8 wherein varying the variable current varies a ratio of the fixed current to the variable current and wherein the output current of the current-to-current conversion circuit is based on the ratio of the fixed current to the variable current.

10. The voltage gain control circuit of any preceding claim wherein the first current mirror resistor is a variable resistor and wherein varying the resistance of the first current mirror resistor varies a ratio of the current gain applied between the first CMT output terminal and the second CMT output terminal.

11. A transmitter circuit for an analog-beamforming circuit comprising the voltage gain control circuit of any preceding claim and further comprising an antenna configured to use the output voltage signal of the current-to-voltage conversion circuit to generate a transmission signal to be output by the antenna.

12. The transmitter circuit of claim 11 further comprising a phase shifter circuit and a power amplifier wherein the phase shifter circuit and the power amplifier circuit are coupled in series with the voltage gain control circuit and the antenna.

13. A receiver circuit for a beamcapturing circuit comprising the voltage gain control circuit of any of claims 1 - 10 and further comprising an antenna configured to receive a wireless signal wherein the receiver circuit is configured to use the voltage gain control circuit to apply a voltage gain to the received wireless signal.

14. A beamforming circuit comprising a plurality of transmitter circuits of claims 11 - 12.

15. An analog-beamcapturing circuit comprising a plurality of receiver circuits of claim 13.
